# EUROPÄISCHE PATENTSCHRIFT

(11) **EP 2 282 969 B1**
(45) Veröffentlichungstag und Bekanntmachung des Hinweises auf die Patenterteilung: **27.07.2016**
(21) Anmeldenummer: 09749684.8
(22) Anmeldetag: 03.04.2009
(51) Int. Cl.: G01L 9/00, H01L 21/3065, H04R 19/00, H04R 31/00

(54) **VERFAHREN ZUR HERSTELLUNG VON VEREINZELTEN, AUF EINEM SILIZIUMSUBSTRAT ANGEORDNETEN MIKROMECHANISCHEN BAUTEILEN UND HIERAUS HERGESTELLTE BAUTEILE**
METHOD FOR THE PRODUCTION OF SEPARATE MICROMECHANICAL PARTS ARRANGED ON A SILICON SUBSTRATE, AND PARTS MADE THEREWITH
PROCÉDÉ POUR PRODUIRE DES COMPOSANTS MICROMÉCANIQUES INDIVIDUELS PLACÉS SUR UN SUBSTRAT DE SILICIUM ET COMPOSANTS PRODUITS SELON CE PROCÉDÉ

(30) Priorität: 23.05.2008 DE 102008001952
(43) Veröffentlichungstag der Anmeldung: 16.02.2011
(73) Patentinhaber: Robert Bosch GmbH, 70442 Stuttgart (DE)
(72) Erfinder: LAERMER, Franz, 71263 Weil Der Stadt (DE); TEEFFELEN, Kathrin, 70569 Stuttgart (DE); LEINENBACH, Christina, 66806 Ensdorf (DE)
(86) Internationale Anmeldenummer: PCT/EP2009/054037
(87) Internationale Veröffentlichungsnummer: WO 2009/141194

(56) Entgegenhaltungen:
- US-A1- 2004 110 359
- US-A1- 2006 040 472
- US-A1- 2006 141 760
- US-A1- 2007 105 345
- AMER M S ET AL: "Femtosecond versus nanosecond laser machining: comparison of induced stresses and structural changes in silicon wafers" APPLIED SURFACE SCIENCE, ELSEVIER, AMSTERDAM, NL LNKD- DOI:10.1016/J.APSUSC.2004.08.029, Bd. 242, Nr. 1-2, 31. März 2005 (2005-03-31), Seiten 162-167, XP025284852 ISSN: 0169-4332 [gefunden am 2005-03-31]

## Beschreibung

### Stand der Technik

Die vorliegende Erfindung betrifft ein Verfahren zur Herstellung von vereinzelten, auf einem Siliziumsubstrat angeordneten mikromechanischen Bauteilen. Sie betrifft weiterhin ein mikromechanisches Bauteil, welches durch ein Verfahren gemäß der vorliegenden Erfindung hergestellt wurde.

Bei der Fertigung mikromechanischer Sensoren mit Membranstrukturen unterschiedlichster Funktionalität stellt die Chipvereinzelung der fertig prozessierten Bauteile mittels Sägen einen an sich bekannten Prozess dar. Zur Membranherstellung besonders für Mikrofone und Drucksensoren kann rückseitig ein Kavernenvolumen erzeugt werden. Bei geschlossenen Membranen, welche eine Abdichtungsfunktion von der Vorderseite zur Rückseite und auch eine vergleichsweise hohe mechanische Stabilität besitzen, kann ein konventioneller Wafer-Sägeprozess ohne besonders hohes Risiko der Membranschädigung angewendet werden. Auch besteht bei geschlossenen Membranen beim Sägen von der Wafervorderseite her kein hohes Risiko eines irreversiblen Verklebens der Membran mit darunterliegenden Schichten infolge der beim Sägen verwendeten Flüssigen Medien zur Beseitigung von Sägeschlamm.

Bei strukturierten Membranen sind jedoch die Verhältnisse anders. Diese Membranen sind nicht mehr vollständig geschlossen, da sie beispielsweise perforiert sind. Solche strukturieren Membranen können zum Beispiel zur Stress-Entkopplung eingesetzt werden, da durch geeignete Membrangeometrien eine Unabhängigkeit der Empfindlichkeit von intrinsischen Schichtstressparametern über das Design erreicht werden kann. Solche designbedingten Maßnahmen, um sich von schwer beherrschbaren Schichtparametern wie dem intrinsischen Stress unabhängig zu machen, spielen unter anderem für die Herstellung von Mikrofonen mit hoher Reproduzierbarkeit und Ausbeute eine große Rolle. Bei solchen Membranen entfällt jedoch die Abdichtungsfunktion zur Waferrückseite hin, was das Sägen unter Einsatz von flüssigen Medien verkompliziert und hohe Risiken für das Bauteil durch Eindringen von Flüssigkeit und Schmutz in die kapazitive Aufnehmerstruktur mit sich bringt.

Neben dem klassischen Wafer-Sägen stellt das sogenannte "Stealth Dicing", auch bekannt unter dem Begriff "Mahoh Dicing", eine Alternative zur Chipvereinzelung dar. Dabei erfolgt eine Amorphisierung des Wafermaterials mittels eines Laserstrahls, wodurch mechanische Spannungen in dem Wafer induziert werden. Die so erzeugten Sollbruchstellen bewirken bei Expansion des Wafers auf einer Folie die Vereinzelung der Chips. Bei diesem Verfahren wird effektiv kein Material abgetragen, so dass die Notwendigkeit von flüssigen Medien während des Vereinzelungsprozesses zum Abtransport von überschüssigem Material eliminiert wird. Nachteilig an diesem Verfahren ist jedoch, dass je nach Waferdicke mehrere oder sogar zahlreiche Laser-Scans erforderlich sind. Dadurch sinkt wiederum der Waferdurchsatz und die Kosten des Verfahrens steigen an.

DE 197 30 028 C2 offenbart ein Verfahren zum kantengenauen Trennen und Bearbeiten von auf einem Halbleitersubstrat im Verband hergestellten Halbleiterchips aus AIII-BV-Verbindungshalbleitern unter Verwendung eines Excimer-Lasers. Der Excimer-Laser arbeitet im Bereich von ≤ 100 fs Pulsdauer und ≤ 250 nm Wellenlänge. Im Verfahren wird ein im Verhältnis zur Gesamtlänge der Trennlinie kurzer Initialschnitt an einer Substratkante durch Verlagern der Auftreff-Fläche des Laserstrahls erzeugt. Der Initialschnitt ist ausgerichtet in Trennlinienrichtung einer zu bearbeitenden Substratoberfläche entlang der gewünschten, in einer Spaltebene, die einer Kristallisierungsrichtung des Halbleitersubstrats entspricht, gelegenen Trennlinie. Der Initialschnitt wird als Auskerbung derart erzeugt, dass es zu einem selbsttätigen Spaltvorgang und damit zum Trennen der Halbleiterchips in der Trennlinienrichtung führt. Nachteilig ist hieran, dass zur Erzeugung des Initialschnitts laut der Beschreibung hohe Leistungsdichten zwischen 5 × 10¹³ und 2 × 10¹⁴ W/cm² nötig sind.

Aus der US 2004/0110359 A1 ist ein Verfahren zur Verbindung zweier Siliziumsubstrate bekannt. Beide Substrate werden aneinander gebracht und an der Verbindungsstelle mit einem Laser geeigneter Wellenlänge derart bestrahlt, dass die beiden Substrate elektrisch oder mechanisch miteinander verbunden werden.

Aus dem Artikel "Femtosecond versus nanosecond laser machining: Comparison of induced stresses and structural changes in silicon wafers" APPLIED SURFACE SCIENCE, ELSEVIER, AMSTERDAM, NL LNKD- DOI: 10.1016/J.APSUSC. 2004.08.029, Bd. 242, Nr. 1-2, 31. März 2005, Seiten 162-167, XP025284852" ist eine Untersuchung von induziertem Stress und Armophisierung eines Siliziumeinkristalls mittels Laser beschrieben.

Aus der US 2006/0141760 A1 ist ein Verfahren zur Herstellung eines elektrischen Bauteils bekannt, bei dem zwei Substrate miteinander verbunden werden. In einem Substrat werden Gräben eingebracht, so dass im Bereich der Verbindungsstelle Teile des Substrats mit den Gräben entfernt werden kann.

Aus der US 2007/0105345 A1 ein Verfahren zur Vereinzelung eines Halbleiterwafers bekannt, bei der auf der Rückseite einer Hauptfläche eines Wafers zunächst Gräben eingebracht werden und anschließend mit Hilfe eines Lasers von der Rückseite des Halbleiterwafers eine Auftrennung des Wafers erfolgt.

Aus der US 2006/0040472 A1 ist ein Verfahren zum Auftrennen eines Halbleitersubstrats entlang einer vorgegebenen Linie mit Hilfe eines Lasers bekannt.

### Offenbarung der Erfindung

Erfindungsgemäß vorgeschlagen wird daher ein Verfahren zur Herstellung von vereinzelten, auf einem Siliziumsubstrat angeordneten mikromechanischen Bauteilen, gemäss Anapruch 1.

Mikromechanische Bauteile im Sinne der vorliegenden Erfindung sind insbesondere Bauteile, deren Strukturen Abmessungen im Bereich von ≥ 1 µm bis ≤ 2000 µm aufweisen. Als Folge der Details der Herstellung werden sie üblicherweise von einem Siliziumsubstrat getragen oder werden zumindest teilweise aus einem strukturierten Substrat aufgebaut. Das Siliziumsubstrat kann ein Siliziumwafer, vorzugsweise ein polykristalliner oder einkristalliner Wafer, sein. Dass die Bauteile vereinzelt sind, bedeutet, dass das vormals eine Mehrzahl von Bauteilen tragende Substrat so zerteilt wurde, dass einzelne oder kleinere Gruppen von Bauteilen vorliegen.

Das erfindungsgemäße Verfahren ist als Kombination eines Vereinzelungsverfahrens mit Schritten eines Herstellungsverfahrens für mikromechanischen Bauteile durchgeführt werden.

In dem Verfahren betrifft zunächst in Schritt a) das Ätzen von Vereinzelungsgräben, entlang welcher später das Substrat getrennt werden soll. Hierzu wird ein anisotropes Plasma-Tiefenätzverfahren verwendet. Solch ein Verfahren bezeichnet eine Ätzmethode, welche beispielsweise Gräben mit einer Tiefe von ≥ 100 µm bis ≤ 800 µm oder von ≥ 400 µm bis ≤ 700 µm in einem Siliziumsubstrat bereitstellen kann. Als Beispiel sei das deep reactive ion etching (DRIE)-Verfahren genannt.

Schritt b) des Verfahrens beinhaltet das Bestrahlen des Bodens eines oder mehrerer Vereinzelungsgräben mit Laserlicht. Das Laserlicht kann dabei von der Seite des Substrats eingestrahlt werden, auf der der Vereinzelungsgraben angelegt wurde. Ebenso ist es aber möglich, dass der Boden von der Rückseite des Substrats her bestrahlt wird. Als Folge der Laserbestrahlung wird der bestrahlte Bereich amorphisiert, was mit einer Abnahme der mechanischen Festigkeit einhergeht. Durch die Absorption des Laserlichts, welches zum Beispiel Infrarot-Licht mit einer Wellenlänge von 1064 nm sein kann, erwärmt sich das Material an dieser Stelle. Der Erwärmungsbereich kann Abmessungen von ≤ 4 µm aufweisen. Durch die Erwärmung erfolgt eine Umwandlung des Materials. Damit verbunden kommt es auch zu einer Volumenzunahme an dieser Stelle. Die Folge ist eine Sollbruchstelle im Wafer, an der die Chips beim Expandieren vereinzelt werden können.

Die abschließende Vereinzelung der Bauteile erfolgt in Schritt c). Mechanische Spannungen können beispielsweise Zugspannungen oder Biegespannungen sein. Ein Weg, um sie zu induzieren, ist durch das Aufkleben des Substrats auf eine Folie mit anschließender horizontaler Streckung der Folie. Durch die mechanischen Spannungen wird im Endergebnis der Wafer an den durch die amorphisierten Bereiche der Vereinzelungsgräben vorgegebenen Stellen getrennt.

Das erfindungsgemäße Verfahren hat den Vorteil, dass zu entfernende Rückstände im wesentlichen verhindert werden. Das anisotrope Plasma-Tiefenätzverfahren verwendet gasförmige Ätzmittel und es werden gasförmige Reaktionsprodukte gebildet. Die Amorphisierung des Siliziumsubstrats mit nachfolgender Trennung durch mechanische Spannungen kommt ebenfalls ohne Materialabtrag aus.

In einer Ausführungsform des erfindungsgemäßen Verfahrens ist das Ätzverfahren in Schritt a) ein Verfahren zum anisotropen Plamaätzen von mit einer Ätzmaske definierten Strukturen in einem Siliziumsubstrat durch die jeweils alternierend aufeinanderfolgende, separate Durchführung von unabhängig voneinander steuerbaren Ätzschritten und Polymerisationsschritten,
wobei das Siliziumsubstrat auf einer Substratelektrode in einem Reaktor angeordnet ist und
wobei während des Polymerisationsschrittes auf die durch die Ätzmaske definierten Strukturen ein Polymer aufgebracht wird, das während des nachfolgenden Ätzschrittes teilweise wieder abgetragen wird und wobei die Ätzschritte ohne Polymerbildner im Plasma durchgeführt werden,
wobei für die Polymerisationsschritte Fluorkohlenwasserstoffe mit einem Atomverhältnis von Fluor zu Kohlenstoff in einem Bereich von ≥1:3 bis ≤ 3:1 eingesetzt werden,
wobei die durch die vorhergehenden Ätzschritte freigelegten Flächen mit einem Fluor-Kohlenstoff-Polymer bedeckt werden,
wobei für die Ätzschritte Fluor liefernde Ätzgase eingesetzt werden und
wobei die Substratelektrode während der Ätzschritte mit einer Hochfrequenz niedriger Leistung beaufschlagt wird.

Varianten dieses Ätzverfahrens sind auch als Bosch-Verfahren bekannt. Mit solch einem Ätzverfahren können tiefe Graben mit nahezu senkrechten Wänden geätzt werden. Die Abweichung der Grabenwände von der Senkrechten beträgt in der Regel nicht mehr als ± 2°. Als Polymer bildende Substanzen können beispielsweise C₄F₈ oder ein Gemisch aus CHF₃ und Argon eingesetzt werden. Vorzugsweise ist das sich bildende Fluor-Kohlenstoff-Polymer chlorfrei. Für die Ätzschritte kann ein Gemisch aus SF₆ und Argon eingesetzt werden. Während der Ätzschritte kann die Ionenenergie in einem Bereich von ≥ 1 eV bis ≤ 50 eV, vorzugsweise von ≥ 5 eV bis ≤ 30 eV liegen. Während der Polymerisationsschritte kann die Ionenenergie in einem Bereich von ≥ 1 eV bis ≤ 10 eV, vorzugsweise von ≥ 4 eV bis ≤ 6 eV liegen. Das Beaufschlagen der Substratelektrode kann vorzugsweise mit Mikrowellenstrahlung bei Leistungen von ≥ 100 W bis ≤ 1500 W oder von ≥ 300 W bis ≤ 1200 W erfolgen.

In einer weiteren Ausführungsform des erfindungsgemäßen Verfahrens weist das Laserlicht in Schritt b) eine Leistung von ≥ 0,7 Watt bis ≤ 1,2 Watt auf. Die Laserleistung kann auch in einem Bereich von ≥ 0,8 Watt bis ≤ 1,1 Watt liegen. Erfindungsgemäß weiterhin eingeschlossen ist eine Schwankung der Laserleistung während des Betriebs um ± 0,02 Watt. Bei solchen Laserleistungen kann die Amorphisierung des Substratmaterials auf die Vereinzelungsgräben begrenzt werden.

In einer weiteren Ausführungsform des erfindungsgemäßen Verfahrens werden während des Ätzens von Vereinzelungsgräben in Schritt a) gleichzeitig Kavernen als Teil der mikromechanischen Bauteile in das Siliziumsubstrat geätzt. Beispiele für Bauteile mit Kavernen oder Hohlräumen sind Mikrofonen oder Drucksensoren. Durch die Wahl der lateralen Abmessungen der Vereinzelungsgräben kann dabei die gewünschte Ätztiefe während des Plasmaätzens über den für das jeweilige Ätzrezept zuvor bestimmten RIE-lag-Faktor bestimmt werden. Dieser reactive ion etching lag-Faktor besagt, dass in diesen Ätzverfahren die Ätzgeschwindigkeit für Gräben bei geringer Grabenbreite niedriger ist als die Ätzgeschwindigkeit bei größerer Grabenbreite. Die Vereinzelungsgräben werden hierbei so dimensioniert, dass sie schmaler als die Kavernen sind.

Folglich werden die Vereinzelungsgräben auch weniger tief geätzt als die Kavernen. Bei bekanntem und vorhergehend charakterisiertem RIE-lag-Effekt kann durch die Wahl der Grabenbreite relativ zur Kavernenbreite also vorherbestimmt werden, wie tief jeweils die Vereinzelungsgräben bei der Anlage der Kavernen gleichzeitig ins Silizium geätzt werden. Die Tiefe der Vereinzelungsgräben wird vorzugsweise so eingestellt, dass das Siliziumsubstrat nach dem Ätzschritt im weiteren Fertigungsverlauf noch stabil und ohne Bruchrisiken gehandhabt werden kann.

Vorteilhaft an dieser Ausführungsform ist insbesondere, dass das Anlegen der Vereinzelungsgräben in einem ohnehin für die Strukturierung der Kavernen vorzunehmenden Verfahrensschritt erfolgt. Es ist also kein weiterer Ätzschritt notwendig. Das Siliziumsubstrat wird im Bereich der Vereinzelungsgräben so dünn, dass bestenfalls nur einmal mit dem Laser bestrahlt werden muss, um eine ausreichende Amorphisierung zu erreichen. Durch die verringerte Schnitttiefe für den Laserprozess fallen an dieser Stelle deutlich verringerte Prozesszeiten und Prozesskosten an. Durch die Möglichkeit, die Tiefe und Breite der Vereinzelungsgräben während eines Ätzprozesses für die Kavernen und gleichzeitig mit diesem durch die Maskengeometrie, vor allem über die Breite der Vereinzelungsgräben, durch den RIE-lag-Effekt zu definieren, sind fast beliebige Chipgrößen und Ätztiefen möglich. Dadurch ist eine hohe Designfreiheit gegeben und der Vereinzelungsprozess wird unabhängig von aufwendigen Anlagenänderungen, wie dieses beispielsweise bei einem Wechsel zwischen Sägeblättern einer konventionellen Wafersäge mit unterschiedlicher Schnittbreite notwendig wäre.

Weiterhin ist es möglich, dass die Kavernen zumindest teilweise von Membranen bedeckt werden. Eine Membran kann zum Beispiel eine Mikrofonmembran oder eine Drucksensormembran sein. Die Membran kann strukturiert sein, also auch Unterbrechungen wie beispielsweise Löcher aufweisen. Das erfindungsgemäße Verfahren ist für Bauteile mit Membranen besonders geeignet, da empfindliche Membranbereiche durch mechanische Einwirkungen während des Vereinzelungsprozesses nicht beschädigt werden und auf Schutzabdeckungen gegen Flüssigkeits- und Materialablagerungen verzichtet werden kann. Die Kavernen können vorteilhafterweise eine Breite von ≥ 50 µm bis ≤ 2000 µm oder von ≥ 400 µm bis ≤ 1000 µm aufweisen. Die Vereinzelungsgräben können eine Breite von ≥ 1 µm bis ≤ 100 µm oder von ≥ 10 µm bis ≤ 30 µm aufweisen. Weiterhin können die Breite der Kavernen und die Breite der Vereinzelungsgräben in einem Verhältnis von ≥ 5:1 bis ≤ 50:1 oder von ≥ 10:1 bis ≤ 30:1 stehen. Bei diesen relativen Breitenverhältnissen kann bei handelsüblichen Siliziumwafern das Tiefenverhältnis von Kaverne und Vereinzelungsgraben günstig eingestellt werden. Unterschiedliche Ätztiefen können somit über das Verhältnis der lateralen Abmessungen gesteuert werden.

Die vorliegende Erfindung wird weiter anhand der nachfolgenden Zeichnungen erläutert. Es zeigen:
- FIG. 1: einen strukturierten Siliziumwafer
- FIG. 2: den Siliziumwafer aus FIG. 1 während des Laserschneidens

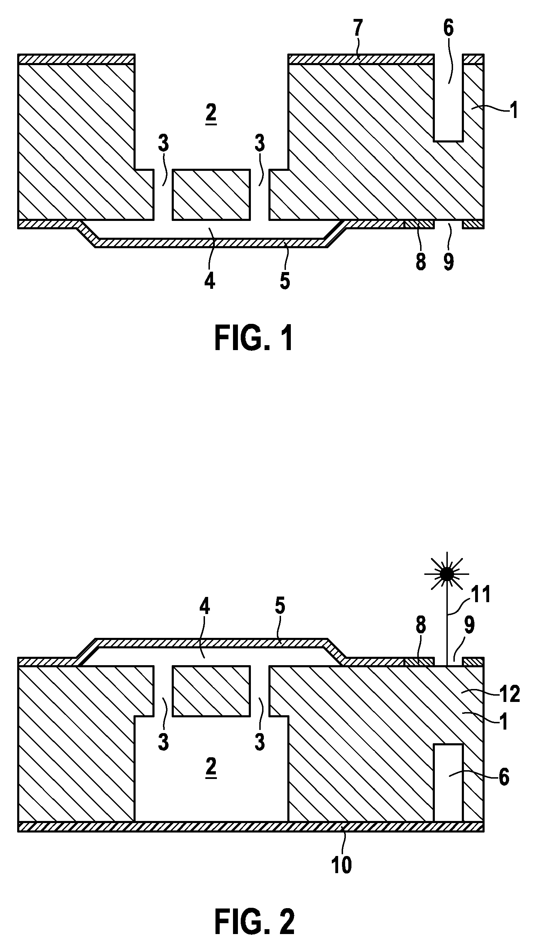

FIG. 1 zeigt einen strukturierten Siliziumwafer nach dem anisotropen Plasma-Tiefenätzschritt. Das Siliziumsubstrat 1 wurde so geätzt, dass die Kaverne 2, die Perforationslöcher 3 durch das Substrat 1 sowie der Hohlraum 4 zwischen Substrat 1 und Membran 5 aufgebaut wurde. Weiterhin wurde zugleich zum Ätzen der Kaverne 2 der Vereinzelungsgraben 6 angelegt. Durch den anisotropen Ätzprozess können Kaverne 2 und Vereinzelungsgraben 6 im Prinzip mit senkrechten Seitenwänden erzeugt werden. Unter Ausnutzung des RIE-lag-Effekts wird dabei der Vereinzelungsgraben 6 mit einer geringeren Ätztiefe erzeugt als die Kaverne 2. Auf der der Membran abgewandten Seite des Substrats 1 befinden sich noch Reste einer Maskierschicht 7. Die membranseitige Oberfläche des Substrats 1 ist an den Stellen, an denen sich keine Membran 4 befindet, teilweise von einer weiteren Maskierschicht 8 abgedeckt. Diese Maskierschicht 8 wird jedoch durch einen unmaskierten Bereich 9 unterbrochen. Der unmaskierte Bereich 9 liegt in Verlängerung des Vereinzelungsgrabens 6 und bildet letztendlich auch dessen Boden. Dadurch, dass die Tiefe des Vereinzelungsgrabens 6 nicht den gesamten Waferquerschnitt umfasst, ist zur weiteren Handhabung des Wafers keine eigene Waferaufnahme in Form einer Folie oder eines Trägersubstrates notwendig. Dieses wiederum hat den Vorteil, dass im Gegensatz zur nachträglichen Ablösung eventueller Schutzschichten für die Membran 5 oder anderer Trägerbereiche von der Vorderseite her die Bereiche um die Membran 5 herum nicht beschädigt werden können.

FIG. 2 zeigt den Siliziumwafer aus FIG. 1 während des Laserschneidens. Gegenüber der Darstellung in FIG. 1 wurde die Maskierschicht 7 entfernt und der Siliziumwafer auf seiner Rückseite mit einer Folie 10 zur späteren Einzelchipaufnahme versehen. Hierdurch können alle weiteren Packaging-Stationen wie gewohnt und mit vorhandener Ausrüstung durchlaufen werden. Der unmaskierte Bereich 9 der membranseitigen Waferoberfläche wird nun mit einem Laserstrahl 11 bestrahlt. Das Siliziumsubstrat in diesem Bereich 9 und das tieferliegende Material 12 werden nun durch die Einwirkung des Laserstrahls 11 amorphisiert. Da bei der Amorphisierung des Siliziummaterials von der Wafervorderseite her bis zu der Tiefe, in der der rückseitig angelegte Vereinzelungsgraben 6 endet, kein Material abgetragen wird, sind auch keine flüssigen Medien zum Materialabtransport oder zur Waferkühlung erforderlich. Nach der Expansion der Folie 10 liegen dann die Bauteile in vereinzelter Form vor, wobei die Trennlinien entlang der zuvor angelegten Vereinzelungsgräben 6 verlaufen.

## Patentansprüche

1. Verfahren zur Herstellung von vereinzelten, auf einem Siliziumsubstrat (1) angeordneten mikromechanischen Bauteilen, umfassend die Schritte:
a) Bereitstellen von Vereinzelungsgräben (6) auf dem Substrat durch ein anisotropes Plasma-Tiefenätzverfahren,
wobei während des Ätzens von Vereinzelungsgräben (6) in Schritt a) gleichzeitig Kavernen (2) als Teil der mikromechanischen Bauteile in das Siliziumsubstrat (1) geätzt werden,
b) Bestrahlen des Bereichs (9, 12) des Siliziumsubstrats (1), welcher den Boden von Vereinzelungsgräben (6) bildet, mit Laserlicht (11), wobei durch das Bestrahlen in diesem Bereich (9, 12) das Siliziumsubstrat (1) von einem kristallinen Zustand in einen zumindest teilweise amorphen Zustand überführt wird;
c) Induzieren von mechanischen Spannungen im Substrat (1) derart, dass das Substrat (1) durch die mechanischen Spannungen an den durch die amorphisierten Bereiche der Vereinzelungsgräben vorgegebenen Stellen getrennt wird.

2. Verfahren gemäß Anspruch 1, wobei das Ätzverfahren in Schritt a) ein Verfahren zum anisotropen Plamaätzen von mit einer Ätzmaske definierten Strukturen in einem Siliziumsubstrat (1) durch die jeweils alternierend aufeinanderfolgende, separate Durchführung von unabhängig voneinander steuerbaren Ätzschritten und Polymerisationsschritten ist,
wobei das Siliziumsubstrat (1) auf einer Substratelektrode in einem Reaktor angeordnet ist und
wobei während des Polymerisationsschrittes auf die durch die Ätzmaske definierten Strukturen ein Polymer aufgebracht wird, das während des nachfolgenden Ätzschrittes teilweise wieder abgetragen wird und wobei die Ätzschritte ohne Polymerbildner im Plasma durchgeführt werden,
wobei für die Polymerisationsschritte Fluorkohlenwasserstoffe mit einem Atomverhältnis von Fluor zu Kohlenstoff in einem Bereich von ≥1:3 bis ≤ 3:1 eingesetzt werden,
wobei die durch die vorhergehenden Ätzschritte freigelegten Flächen mit einem Fluor-Kohlenstoff-Polymer bedeckt werden,
wobei für die Ätzschritte Fluor liefernde Ätzgase eingesetzt werden und
wobei die Substratelektrode während der Ätzschritte mit einer Hochfrequenz niedriger Leistung beaufschlagt wird.

3. Verfahren gemäß Anspruch 1 oder 2, wobei das Laserlicht in Schritt b) eine Leistung von ≥ 0,7 Watt bis ≤ 1,2 Watt aufweist.

4. Verfahren nach einem der vorhergehenden Ansprüche, wobei die Kavernen (2) zumindest teilweise von Membranen (5) bedeckt werden.

5. Verfahren nach einem der vorhergehenden Ansprüche, wobei die Kavernen (2) eine Breite von ≥ 50 µm bis ≤ 2000 µm aufweisen.

6. Verfahren nach einem der vorhergehenden Ansprüche, wobei die Breite der Kavernen (2) und die Breite der Vereinzelungsgräben (6) in einem Verhältnis von ≥ 5:1 bis ≤ 50:1 stehen.

## Claims

1. Method for producing singulated micromechanical components arranged on a silicon substrate (1), comprising the following steps:
a) providing singulation trenches (6) on the substrate by means of an anisotropic plasma deep etching method, wherein during the etching of singulation trenches (6) in step a) cavities (2) as part of the micromechanical components are simultaneously etched into the silicon substrate (1),
b) irradiating the region (9, 12) of the silicon substrate (1) which forms the bottom of singulation trenches (6) with laser light (11), wherein the silicon substrate (1) is converted from a crystalline state into an at least partly amorphous state as a result of the irradiating in said region (9, 12),
c) inducing mechanical stresses in the substrate (1) in such a way that the substrate (1) is separated by the mechanical stresses at the locations predefined by the amorphized regions of the singulation trenches.

2. Method according to Claim 1, wherein the etching method in step a) is a method for the anisotropic plasma etching of structures defined by an etching mask in a silicon substrate (1) by means of the respectively alternately successive, separate performance of mutually independently controllable etching steps and polymerization steps,
wherein the silicon substrate (1) is arranged on a substrate electrode in a reactor, and
wherein during the polymerization step a polymer is applied to the structures defined by the etching mask, said polymer being partly removed again during the subsequent etching step, and wherein the etching steps are performed without polymer formers in the plasma, wherein fluorocarbons having an atomic ratio of fluorine to carbon in a range of ≥ 1:3 to ≤ 3:1 are used for the polymerization steps,
wherein the surfaces exposed by the previous etching steps are covered with a fluorine-carbon polymer, wherein etching gases that supply fluorine are used for the etching steps, and
wherein a low-power radio frequency is applied to the substrate electrode during the etching steps.

3. Method according to Claim 1 or 2, wherein the laser light in step b) has a power of ≥ 0.7 watt to ≤ 1.2 watts.

4. Method according to any of the preceding claims, wherein the cavities (2) are at least partly covered by membranes (5).

5. Method according to any of the preceding claims, wherein the cavities (2) have a width of ≥ 50 µm to ≤ 2000 µm.

6. Method according to any of the preceding claims, wherein the width of the cavities (2) and the width of the singulation trenches (6) are in a ratio of ≥ 5:1 to ≤ 50:1.

## Revendications

1. Procédé de fabrication de composants micromécaniques isolés agencés sur un substrat en silicium (1), comprenant les étapes suivantes :
a) la préparation de sillons d'isolement (6) sur le substrat par un procédé de gravure plasma en profondeur anisotrope,
des cavernes (2) étant gravées simultanément dans le substrat en silicium (1) en tant que partie des composants micromécaniques pendant la gravure des sillons d'isolement (6) à l'étape a),
b) l'exposition de la zone (9, 12) du substrat en silicium (1) qui forme le fond des sillons d'isolement (6) à une lumière laser (11), le substrat en silicium (1) étant transformé d'un état cristallin à un état au moins partiellement amorphe par l'exposition dans cette zone (9, 12) ;
c) l'induction de tensions mécaniques dans le substrat (1) de sorte que le substrat (1) soit séparé par les tensions mécaniques aux emplacements prédéterminés par les zones amorphisées des sillons d'isolement.

2. Procédé selon la revendication 1, dans lequel le procédé de gravure à l'étape a) est un procédé de gravure plasma anisotrope de structures définies avec un masque de gravure dans un substrat en silicium (1) par la réalisation séparée, successivement en alternance, d'étapes de gravure et d'étapes de polymérisation ajustables indépendamment les unes des autres,
le substrat en silicium (1) étant agencé sur une électrode substrat dans un réacteur et
un polymère étant appliqué pendant l'étape de polymérisation sur les structures définies par le masque de gravure, et partiellement retiré pendant l'étape de gravure ultérieure, et les étapes de gravure étant réalisées sans agent de formation polymère dans le plasma,
des hydrocarbures fluorés ayant un rapport atomique entre le fluor et le carbone dans une plage allant de ≥ 1:3 à ≤ 3:1 étant utilisés pour les étapes de polymérisation,
les surfaces libérées par les étapes de gravure précédentes étant recouvertes avec un polymère fluor-carbone,
des gaz de gravure fournissant du fluor étant utilisés pour les étapes de gravure, et
l'électrode substrat étant exposée pendant les étapes de gravure à une fréquence élevée de faible puissance.

3. Procédé selon la revendication 1 ou 2, dans lequel la lumière laser à l'étape b) présente une puissance de ≥ 0,7 watt à ≤ 1,2 watt.

4. Procédé selon l'une quelconque des revendications précédentes, dans lequel les cavernes (2) sont au moins partiellement recouvertes par des membranes (5).

5. Procédé selon l'une quelconque des revendications précédentes, dans lequel les cavernes (2) présentent une largueur de ≥ 50 µm à ≤ 2 000 µm.

6. Procédé selon l'une quelconque des revendications précédentes, dans lequel la largeur des cavernes (2) et la largeur des sillons d'isolement (6) présentent un rapport de ≥ 5:1 à ≤ 50:1.
